(19) Europäisches Patentamt
European Patent Office
Office européen des brevets

(11) EP 2 003 650 B1

## (12) FASCICULE DE BREVET EUROPEEN

(45) Date de publication et mention de la délivrance du brevet:
**04.11.2009 Bulletin 2009/45**

(51) Int Cl.:
***G11C 11/417*** (2006.01)

(21) Numéro de dépôt: **08354031.0**

(22) Date de dépôt: **26.05.2008**

(54) **Cellule mémoire SRAM asymétrique à 4 transistors double grille**

Asymmetrische SRAM-Speicherzelle mit 4 Doppelgate-Transistoren

Asymmetric SRAM memory cell with 4 double-gate transistors

(84) Etats contractants désignés:
**DE GB IT**

(30) Priorité: **04.06.2007 FR 0703955**

(43) Date de publication de la demande:
**17.12.2008 Bulletin 2008/51**

(73) Titulaire: **Commissariat à l'Energie Atomique**
**75015 Paris (FR)**

(72) Inventeurs:
- **Giraud, Bastien**
  **83310 Sanary sur Mer (FR)**
- **Amara, Amara**
  **92330 Sceaux (FR)**

(74) Mandataire: **Jouvray, Marie-Andrée et al**
**Cabinet HECKE**
**10 Rue d'Arménie**
**Europole**
**BP 1537**
**38025 Grenoble Cedex 1 (FR)**

(56) Documents cités:
**FR-A- 2 898 432     US-A1- 2006 274 569**

- **KENJI NODA: "A loadless CMOS Four-Transistor SRAM Cell in a 0.18 micron Logic Technology" IEEE TRANSACTIONS ON ELECTRON DEVICES, vol. 48, no. 12, 12 décembre 2001 (2001-12-12), pages 2851-2855, XP002466464 Extrait de l'Internet: URL:http:// ieeexplore.ieee.org/iel5/16/210 13/00974716.pdf>**

**Description**

**Domaine technique de l'invention**

L'invention est relative à une cellule mémoire vive de type SRAM comportant un transistor d'accès, ayant une première électrode de grille connectée à une ligne de mot une première électrode de source/drain connectée à une ligne de bit, et une seconde électrode de source/drain connectée à une électrode de grille d'un premier transistor de charge, à une électrode de grille d'un transistor de conduction et à une première électrode de source/drain d'un deuxième transistor de charge, une deuxième électrode de source/drain du deuxième transistor de charge étant connectée à une tension d'alimentation, le premier transistor de charge et le transistor de conduction étant reliés en série aux bornes de la tension d'alimentation.

**État de la technique**

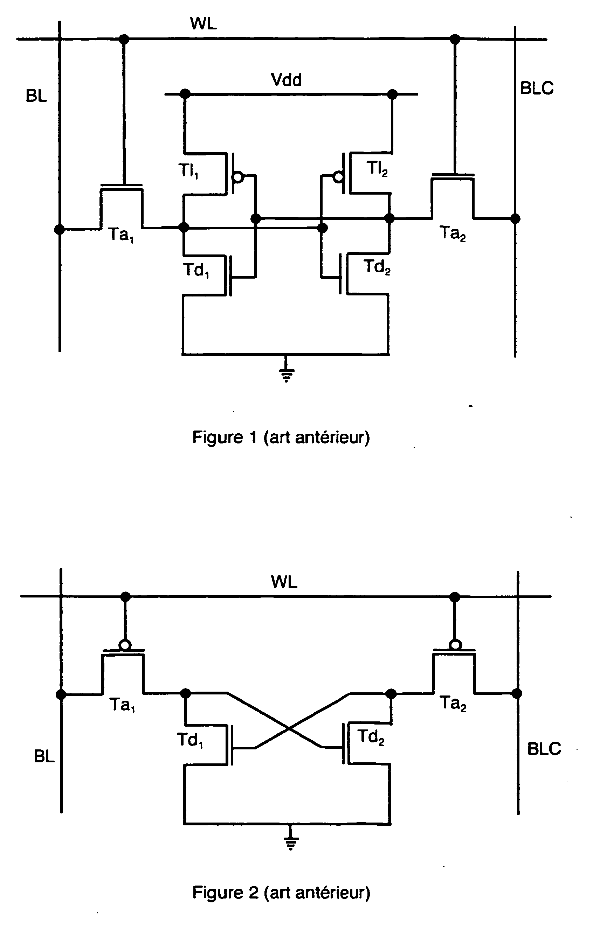

Depuis quelques années, les caractéristiques électriques des transistors sur substrat massif de silicium se sont dégradées avec l'accentuation des effets parasites liés à la réduction des dimensions. Ces modifications du comportement du transistor ont une grande influence sur le fonctionnement des cellules mémoires et rendent alors leur fonctionnement moins robuste. Dans le même temps, la cellule mémoire de type SRAM (« Static Random Acess Memory ») conventionnelle comportant 6 transistors (4 de type NMOS et 2 de type PMOS), illustrée sur la figure 1, occupe une surface trop importante dans les circuits intégrés. Afin de réduire l'importance de ces écueils, de nouvelles architectures voient le jour et doivent permettre la réalisation de cellules mémoires occupant moins de surface, tout en ayant un fonctionnement robuste. De façon conventionnelle, une cellule mémoire à 6 transistors comporte deux transistors d'accès, $Ta_1$, $Ta_2$, ayant une électrode de source/drain connectée à une ligne de bit BL ou à une ligne de bit complémentaire BLC et dont la grille est connectée à une ligne de mot (WL). La cellule comporte également deux transistors de charge, $Tl_1$, $Tl_2$ chacun connecté en série avec un transistor de conduction $Td_1$, $Td_2$, entre les bornes d'une tension d'alimentation Vdd pour former deux inverseurs rétrocouplés. Une autre électrode de source/drain du transistor d'accès est connectée à un des inverseurs au niveau des électrodes de grilles et à l'autre inverseur au niveau des électrodes de source et drain formant le point commun des transistors de charge et de conduction correspondant.

De manière générale, les cellules mémoires SRAM doivent trouver les bons compromis concernant le dimensionnement des transistors NMOS et PMOS et leur organisation de façon à :

- minimiser la surface de la cellule mémoire,
- obtenir des conditions de fonctionnement en écriture et en lecture robustes,
- présenter une certaine immunité aux erreurs,
- présenter un courant de lecture de la cellule compatible avec le circuit associé,
- minimiser le courant de fonctionnement,
- présenter une bonne robustesse vis-à-vis du processus de fabrication.

Ces caractéristiques générales font que les performances électriques des multiples transistors, composant la cellule mémoire, jouent un rôle extrêmement important sur la robustesse de fonctionnement de la cellule mémoire.

Pour un noeud technologique donné, la réduction de surface de la cellule est principalement liée à la réduction du nombre de transistors. Cependant la réorganisation des transistors se traduit toujours par une modification de son fonctionnement. Aujourd'hui, de nombreuses cellules mémoires comportant seulement 4 ou 5 transistors sont proposées. Ces cellules sont généralement connectées à une ligne de mot et à deux lignes de bit.

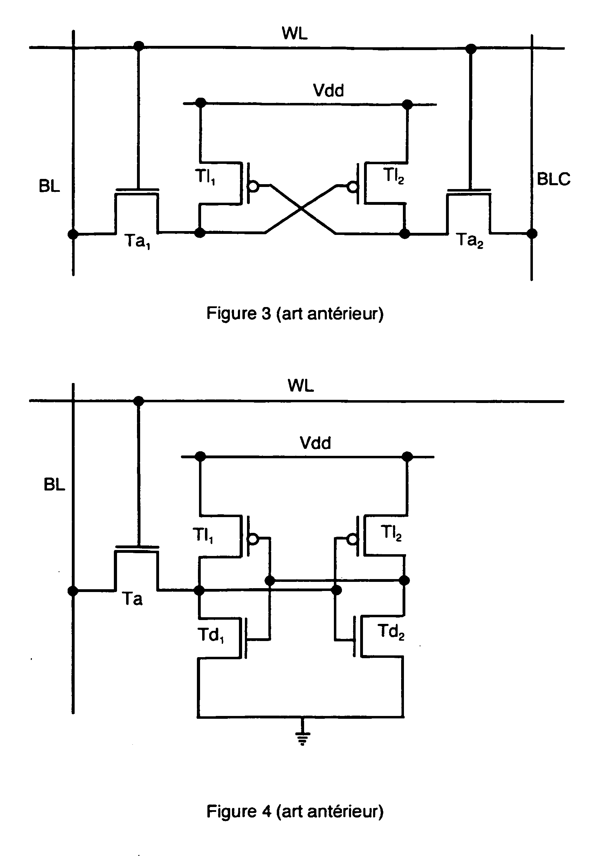

Certaines architectures ont abouti à des cellules mémoires de type « loadless » où les transistors de charge ($Tl_1$, $Tl_2$) ont été éliminés (figure 2). Dans d'autres cas ce sont les deux transistors de conduction ($Td_1$, $Td_2$) qui ont été supprimés (figure 3) et une cellule mémoire de type « driverless » est alors obtenue, comme décrit dans le brevet US 6442060.

De façon générale, les cellules mémoires à 4 transistors ne sont pas suffisamment stables pour garantir un bon fonctionnement en tenant compte des variations du processus de fabrication. En particulier, la cellule mémoire SRAM de type « loadless » comportant 4 transistors est très sensible au décalage des performances électriques des transistors de la cellule et à l'augmentation de la température. Ces deux points entraînent, généralement, l'utilisation de circuits supplémentaires de compensation et réduisent alors, fortement, le gain de surface obtenu en éliminant des transistors de la cellule.

L'utilisation d'une cellule mémoire de type SRAM, comportant un transistor de charge, deux transistors de conduction et un transistor d'accès à été proposée dans le brevet US 7116605. Cette approche permet de réaliser simultanément les opérations d'écriture et de lecture au sein de la cellule tout en minimisant sa taille. Cependant pour obtenir de telles fonctionnalités, cette cellule doit présenter en plus des 4 transistors préalablement décrits, 2 transistors de lecture et 3 lignes de commande, une ligne de bit, une ligne mot et un signal commun. Il en ressort que cette cellule, comportant alors 6 transistors, occupe une surface importante dans le circuit intégré.

Une autre voie autorisant la réduction du nombre de transistors ainsi que la réduction de la consommation électrique, est l'utilisation d'une unique ligne de bit. Dans cette approche, illustrée par la figure 4, un seul transistor d'accès Ta est alors nécessaire. Cette cellule mémoire se distingue de la cellule mémoire selon la figure 1 uniquement par la suppression du second transistor d'accès $Ta_2$.

Cependant, cette approche avec une seule ligne de bit n'est pas couramment utilisée car il existe des problèmes de fiabilité de l'opération d'écriture dans la cellule. Ce type de cellule ne présente donc pas un fonctionnement suffisamment robuste.

En ce qui concerne l'amélioration de la robustesse du fonctionnement de la cellule mémoire, sans augmenter le nombre de transistors dans la cellule, de nombreuses publications décrivent l'utilisation de cellules asymétriques, c'est-à-dire de cellules où les performances électriques de groupes de transistors sont notablement différentes. Cependant, à la différence des cellules symétriques, les points mémoires asymétriques doivent être étudiés selon leur état stocké (haut ou bas pour chacun des points et avec les combinaisons possibles entre ces points).

Kim et al. (« Independent-Gate Controlled Asymmetrical SRAM Cells in Double-Gate Technology for Improved READ Stability », Proceeding of the 32nd European Solid state conference ESSCIRC, September 2006) proposent l'utilisation d'une cellule mémoire de type SRAM asymétrique à 6 transistors. Dans cette cellule, la combinaison des transistors de la partie gauche de la cellule ne présente pas les mêmes performances électriques que la combinaison des transistors de la partie droite de la cellule. De cette manière, la phase d'écriture est plus robuste. De plus, Kim et al. décrivent également l'utilisation de transistors à double grille avec deux grilles électriquement indépendantes, reliées à des commandes différentes, pour certains transistors. Cette approche permet d'ajuster les caractéristiques électriques des transistors et ainsi d'améliorer le fonctionnement de la cellule. Cependant, la cellule proposée par Kim et Al. utilise 6 transistors, ce qui représente toujours une surface considérable sur un circuit intégré.

Wang et al. (« Single-Ended SRAM with High Test Coverage and Short Test Time » IEEE journal of Solid State Circuits, vol 35, N° 1 January 2000), décrivent l'utilisation d'une cellule asymétrique présentant un unique transistor d'accès. Ils décrivent également l'utilisation d'un décalage des tensions de seuil entre les inverseurs pour obtenir une cellule mémoire fonctionnelle et présentant une consommation électrique réduite. Il est important de noter que cette cellule mémoire pour être pleinement fonctionnelle doit en fait comporter 6 transistors. Ainsi, la cellule proposée occupe, finalement, sensiblement la même surface qu'une cellule mémoire conventionnelle.

Le document US2006/0274569 décrit la réalisation d'une cellule SRAM à six transistors dont les transistors d'accès et les transistors de conductions sont des transistors à double grille.

**Objet de l'invention**

L'objet de l'invention consiste à pallier les inconvénients précités et en particulier à réaliser une cellule mémoire dont les conditions de fonctionnement soient robustes et qui occupe une surface compatible avec une intégration industrielle.

L'invention est définie par la revendication 1.

Selon l'invention, ce but est atteint par le fait que le transistor d'accès et le deuxième transistor de charge comportent chacun au moins une seconde électrode de grille électriquement indépendante de la première électrode de grille correspondante, la deuxième électrode de grille du transistor d'accès étant connectée à la première électrode de grille du deuxième transistor de charge et la deuxième électrode de grille du deuxième transistor de charge étant reliée à la tension d'alimentation.

**Description sommaire des dessins**

D'autres avantages et caractéristiques ressortiront plus clairement de la description qui va suivre de modes particuliers de réalisation de l'invention donnés à titre d'exemples non limitatifs et représentés aux dessins annexés, dans lesquels :

La figure 1 représente une cellule mémoire vive de type SRAM à 6 transistors selon l'art antérieur.
La figure 2 représente une cellule mémoire vive de type SRAM à 4 transistors de type « loadless » selon l'art antérieur.
La figure 3 représente une cellule mémoire vive de type SRAM à 4 transistors de type « driverless » selon l'art antérieur.
La figure 4 représente une cellule mémoire vive de type SRAM à 5 transistors de type « Single Ended » selon l'art antérieur.
La figure 5 représente un mode particulier de réalisation d'une cellule mémoire vive de type SRAM selon l'invention.
La figure 6 représente une variante de réalisation d'une cellule mémoire vive de type SRAM selon l'invention.

**Description de modes particulier de réalisation**

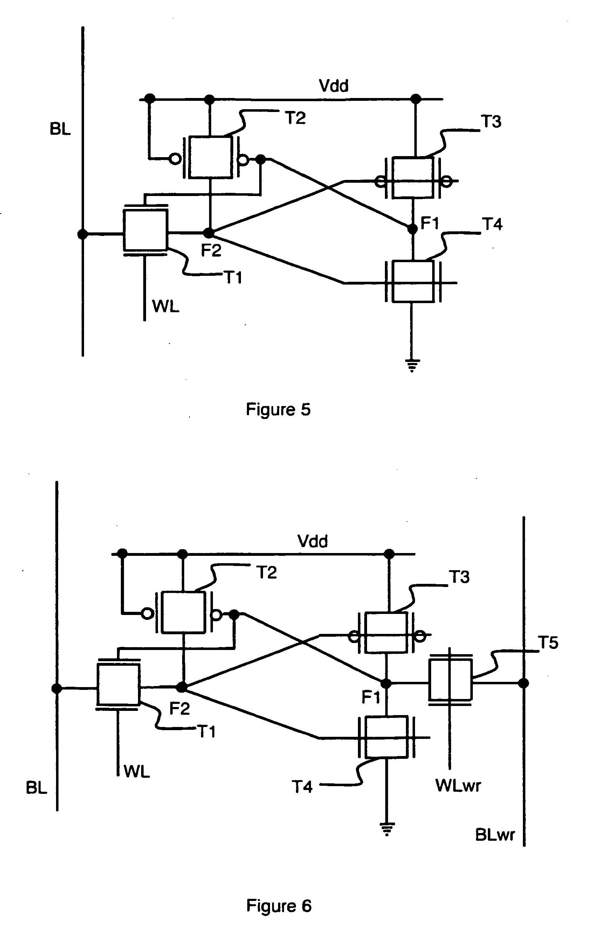

La cellule mémoire vive de type SRAM, illustrée par la figure 5, comporte 4 transistors. Les transistors de charge T2, T3 sont de type opposé aux transistors d'accès T1 et de conduction T4. La cellule mémoire comporte, par exemple, deux transistors de type NMOS, à savoir le transistor d'accès T1 et le transistor de conduction T4, et deux transistors de type PMOS, à savoir les deux transistors de charge T2 et T3.

Le premier transistor de charge T3 et le transistor de conduction T4 sont connectés en série, aux bornes de la tension d'alimentation Vdd et forment ainsi un inverseur. De manière conventionnelle, le premier transistor de charge T3 est connecté à la tension d'alimentation et le transistor de conduction T4 à la masse. Le point commun aux électrodes de source/ drain des transistors de charge T3 et de conduction T4 forme un noeud électrique F1.

La tension d'alimentation a, par exemple, une tension nominale de 1,2V.

Le transistor d'accès T1 et le deuxième transistor de charge T2 comportent au moins une électrode de grille supplémentaire et sont donc au moins des transistors à double grille.

Sur la figure 5, le premier transistor d'accès T1, à double grille, de type NMOS est connecté par une première électrode de source/drain à une ligne de bit BL. Sa seconde électrode de source/drain est, quant à elle, connectée aux électrodes de grilles du transistor de conduction T4 et du premier transistor de charge T3 ainsi qu'à une première électrode de source/drain du deuxième transistor de charge T2. Ces électrodes, connectées entre elles, définissent un noeud électrique F2. La première électrode de grille du transistor d'accès T1 est connectée à la ligne de mot WL et sa seconde électrode de grille est connectée simultanément à la première électrode de grille du deuxième transistor de charge T2 et au noeud électrique F1.

Le deuxième transistor de charge T2 étant connecté par sa première électrode de source/drain au noeud électrique F2, sa seconde électrode de source/drain est connectée à la tension d'alimentation Vdd. Sa première électrode de grille étant reliée au noeud électrique F1, sa seconde électrode de grille est également connectée à la tension d'alimentation Vdd.

L'utilisation de transistors à double grille, c'est-à-dire avec des premières et secondes électrodes de grille électriquement indépendantes, permet de redéfinir avec une plus grande liberté les équations de fonctionnement de la cellule mémoire et autorise alors l'obtention d'un compromis plus avantageux entre la robustesse de fonctionnement et la surface occupée de la cellule. Cependant, la complexité des cellules ainsi obtenues nécessite l'analyse de nombreux critères interdépendants qui permettront d'extraire le meilleur compromis.

Au sein de la cellule mémoire, les transistors de charge T2 et T3, de type PMOS, ont des grilles de longueur $L_P$ et de largeur $W_P$ et le transistor d'accès T1, de type NMOS, a des grilles de longueur $L_A$ et de largeur $W_A$. Les dimensions des transistors définissant en partie leurs performances électriques, il est possible, en ajustant les dimensions des transistors, de trouver un compromis entre la robustesse de fonctionnement et la surface occupée par la cellule mémoire. Avantageusement, avec l'organisation des transistors précédemment définie, les dimensions des transistors doivent satisfaire l'équation $\dfrac{5W_P}{3L_P} \leq \dfrac{W_A}{L_A}$ pour obtenir le meilleur compromis entre la surface occupée et un fonctionnement robuste de la cellule mémoire.

Par ailleurs, afin de favoriser la robustesse des conditions de fonctionnement de la cellule mémoire, le transistor d'accès T1 est préférentiellement déséquilibré. Ce dernier voit alors, par exemple, ses caractéristiques courant/tension redéfinies de sorte que le courant entre le drain et la source soit fortement influencé par la tension appliquée entre la première grille et la source. Le déséquilibre de ce transistor peut être réalisé en intégrant des grilles avec des caractéristiques différentes tout en présentant des grilles de mêmes dimensions. Ce déséquilibre est réalisé par tout moyen connu, par exemple en modifiant les travaux de sortie des matériaux de grille et/ou en modifiant l'épaisseur de l'oxyde de grille, d'une grille à l'autre.

Avantageusement, pour assurer un fonctionnement robuste de la cellule mémoire, dans le transistor d'accès T1, un rapport élevé du courant entre la source et le drain est recherché, typiquement de l'ordre de 13 voire supérieur, pour une tension entre la grille et la source passant de l'état haut à l'état bas sur la deuxième grille, la tension sur la première grille étant toujours à l'état haut.

Il est à noter que la tension appliquée à la deuxième grille sert à augmenter, de manière significative, la stabilité en utilisant le mécanisme de contre-réaction. Le mécanisme de contre-réaction a déjà été utilisé par Yamaoka et al. (« Low Power SRAM Menu for SOC Application using Yin-Yang Feedback Memory Cell Technology » Symp. VLSI Circuits Dig. 18, 2004).

Le transistor de conduction T4 et le premier transistor de charge T3 peuvent être des transistors classiques à une seule électrode de grille ne comportant chacun plus d'une grille. Dans un mode de réalisation privilégié, afin de simplifier le processus de fabrication, tous les transistors composant la cellule mémoire sont à double grille. Dans cette approche, les deux électrodes de grilles du transistor de conduction T4 sont de préférence connectées entre elles. Il en va de même des deux électrodes de grille du premier transistor de charge T3, comme illustré à la figure 5.

A titre d'exemple, les caractéristiques électriques d'une cellule en technologie double grille de type 32nm peuvent être les suivantes :

| Tension alimentation | 1,2 volt |
| --- | --- |
| Longueur de grille (tous transistors) | 50 nm |
| Travail de sortie, première grille du transistor d'accès | 0,1 eV |
| Travail de sortie, seconde grille du transistor d'accès | 0,3 eV |
| Travail de sortie, toutes grilles des autres transistors | -0,0872 eV |
| Epaisseur d'oxyde de grille, de la première grille du transistor d'accès | 1 nm |
| Epaisseur d'oxyde de grille, de la seconde grille du transistor d'accès | 4 nm |
| Largeur de grille $W_P$ des transistors PMOS | 650 nm |
| Largeur de grille $W_N$ du transistor de conduction | 350 nm |
| Largeur de grille $W_A$ du transistor d'accès | 500 nm |

Pour une technologie double grille 32nm, le temps d'écriture, de l'ordre de 330 ps, dans le cas le moins favorable, est 1000 fois plus petit que le temps représentatif de la sensibilité en écriture (« write disturb » en anglais) dans les mêmes conditions. De même, la cellule mémoire présente un très bon compromis entre les stabilités (« Static Noise Margin » en anglais) en rétention et en lecture. En effet, la cellule mémoire présente une stabilité en lecture (de l'ordre de 492mV) et en rétention (de l'ordre de 411mV), supérieure d'au moins 50mV par rapport aux cellules mémoires équivalentes pour la même technologie.

De plus, la cellule mémoire présente un courant statique de l'ordre de 1,49nA, ce qui la place dans la moyenne des consommations proposées par les cellules mémoires connues à 6 ou 4 transistors. Cependant, la cellule mémoire présente une marge en écriture environ deux fois moins élevée que la cellule mémoire comportant 6 transistors mais reste du même ordre que les autres cellules mémoires à 4 transistors (de l'ordre de 0,6V)

Durant une phase de rétention (« rétention mode » en anglais), la ligne de mot WL peut être fixée, de préférence, au potentiel -Vdd/2 afin de réduire les phénomènes d'écriture non désirée. De même, lors d'une phase de lecture, la ligne de mot WL est préférentiellement fixée au potentiel Vdd/2 pour éviter la perte d'information.

A titre d'exemple, en fixant la tension de la ligne de mot WL en rétention à - 0,6V, il a été constaté que la cellule mémoire présente toujours un très bon compromis entre les stabilités en rétention et en lecture. Cependant, la stabilité en lecture (de l'ordre de 502mV) a été améliorée au détriment de celle en rétention (de l'ordre de 258mV). La consommation statique moyenne a été également améliorée et est alors de l'ordre de 1,22nA. La marge en écriture n'a pas évolué et le temps d'écriture (de l'ordre de 261 ps dans le cas le moins favorable) est environ 4500 fois plus petit que le temps relatif à la sensibilité en écriture dans les mêmes conditions.

Dans l'ensemble, la cellule proposée est devenue plus stable et sa consommation a été réduite.

Dans une variante de réalisation, illustrée par la figure 6, un transistor d'accès additionnel T5 est connecté entre le noeud F1 et une ligne de bit d'écriture par ses électrodes de source et de drain. Ce transistor d'accès additionnel T5 comporte au moins une électrode de grille. Dans le cas d'un transistor double grille, les deux grilles sont toutes deux connectées à une ligne de mot d'écriture WLwr. La ligne de bit d'écriture BLwr, la ligne de mot d'écriture WLwr, ainsi que le transistor d'accès additionnel T5 ne sont utilisés que lors de la phase d'écriture. Dans cette variante, il est possible de mettre en place une cellule mémoire à écriture différentielle qui autorise une phase d'écriture plus rapide et qui permet de diminuer la marge en écriture. Dans cette configuration, le temps relatif au phénomène de sensibilité en écriture est conservé. L'opération d'écriture s'effectue par les deux lignes de bit BL et BLwr et est alors plus rapide, alors que l'opération de lecture s'effectue toujours sur la seule ligne de bit BL.

Avantageusement, les dimensions des différents transistors de la cellule peuvent être modifiées selon que la cellule comporte ou non un transistor d'accès additionnel T5. En effet, la cellule mémoire ayant un fonctionnement modifié par l'addition de ce transistor supplémentaire, un nouveau compromis peut être obtenu en définissant, par exemple, de nouveaux rapports $W_A/L_A$, $W_P/L_P$ et $W_N/L_N$. Ainsi, les caractéristiques de la cellule mémoire sont grandement améliorées, les stabilités en lecture et en rétention sont plus élevées, la consommation statique est plus faible. Le rapport de la sensibilité d'écriture sur le temps d'écriture a été multiplié par un facteur quatre.

**Revendications**

1. Cellule mémoire vive de type SRAM comportant un transistor d'accès (T1), ayant une première électrode de grille connectée à une ligne de mot (WL), une première électrode de source/ drain connectée à une ligne de bit (BL), et une seconde électrode de source/drain étant connectée à une électrode de grille d'un premier transistor de charge (T3), à une électrode de grille d'un transistor de conduction (T4) et à une première électrode de source/drain d'un deuxième transistor de charge (T2), une deuxième électrode de source/drain du deuxième transistor de charge (T2) étant connectée à une tension d'alimentation, le premier transistor de charge (T3) et le transistor de conduction (T4) étant reliés en série aux bornes de la tension d'alimentation, la cellule mémoire **caractérisée en ce que** le transistor d'accès (T1) et le deuxième transistor de charge (T2) comportent chacun au moins une seconde électrode de grille électriquement indépendante de la première électrode de grille correspondante, la deuxième électrode de grille du transistor d'accès (T1) étant connectée à la première électrode de grille du deuxième transistor de charge (T2) et la deuxième électrode de grille du deuxième transistor de charge (T2) étant reliée à la tension d'alimentation.

2. Cellule mémoire selon la revendication 1, **caractérisée en ce que** le transistor d'accès (T1) a une caractéristique courant/tension avec un courant de drain dépendant plus fortement de la tension appliquée sur sa première grille que dans les caractéristiques courant tension des autres transistors de la cellule mémoire.

3. Cellule mémoire selon l'une des revendications 1 et 2, **caractérisée en ce que** les transistors de charge (T2, T3) sont de type PMOS.

4. Cellule mémoire selon l'une quelconque des revendications 1 à 3, **caractérisée en ce que** les transistors d'accès (T1) et de conduction (T4) sont de type NMOS.

5. Cellule mémoire selon l'une quelconque des revendications 1 à 4, **caractérisée en ce que** le transistor de conduction (T4) et le premier transistor de charge (T3) comportent chacun une électrode de grille additionnelle.

6. Cellule mémoire selon la revendication 5, **caractérisée en ce que** les deux électrodes de grille du transistor de conduction (T4) sont connectées l'une à l'autre.

7. Cellule mémoire selon l'une des revendications 5 et 6, **caractérisée en ce que** les deux électrodes de grille du premier transistor de charge (T3) sont connectées l'une à l'autre.

8. Cellule mémoire selon l'une quelconque des revendications 1 à 7, **caractérisée en ce qu'**un transistor d'accès additionnel (T5), du même type que le transistor d'accès (T1) et le transistor de conduction (T4), est connecté entre le point commun (F1) au premier transistor de charge (T3) et au transistor de conduction (T4) et une ligne de bit d'écriture (BLwr) et comporte une électrode de grille connectée à une ligne de mot d'écriture (WLwr).

9. Cellule mémoire selon la revendication 8, **caractérisée en ce** le transistor d'accès additionnel (T5) comporte une électrode de grille additionnelle.

10. Cellule mémoire selon la revendication 9, **caractérisée en ce que** les deux électrodes de grilles du transistor d'accès additionnel (T5) sont connectées l'une à l'autre.

**Claims**

1. Random access memory cell of SRAM type comprising an access transistor (T1) having a first gate electrode connected to a word line (WL), a first source/drain electrode connected to a bit line (BL), and a second source/drain electrode being connected to a gate electrode of a first load transistor (T3), to a gate electrode of a driver transistor (T4) and to a first source/drain electrode of a second load transistor (T2), a second source/drain electrode of the second load transistor (T2) being connected to a supply voltage, the first load transistor (T3) and the driver transistor (T4) being connected in series to the terminals of the supply voltage, memory cell **characterized in that** the access transistor (T1) and the second load transistor (T2) each comprise at least one second gate electrode electrically independent from the corresponding first gate electrode, the second gate electrode of the access transistor (T1) being connected to the first gate electrode of the second load transistor (T2) and the second gate electrode of the second load transistor (T2) being connected to the supply voltage.

**2.** Memory cell according to claim 1, **characterized in that** the access transistor (T1) has a current/voltage characteristic with a drain current depending more greatly on the voltage applied to its first gate than the current/voltage characteristics of the other transistors of the memory cell.

**3.** Memory cell according to one of claims 1 and 2, **characterized in that** the load transistors (T2, T3) are of PMOS type.

**4.** Memory cell according to any one of claims 1 to 3, **characterized in that** the access transistor (T1) and driver transistor (T4) are of NMOS type.

**5.** Memory cell according to any one of claims 1 to 4, **characterized in that** the driver transistor (T4) and the first load transistor (T3) each comprise an additional gate electrode.

**6.** Memory cell according to claim 5, **characterized in that** the two gate electrodes of the driver transistor (T4) are connected to one another.

**7.** Memory cell according to one of claims 5 and 6, **characterized in that** the two gate electrodes of the first load transistor (T3) are connected to one another.

**8.** Memory cell according to one of claims 1 to 7, **characterized in that** an additional access transistor (T5), of the same type as the access transistor (T1) and driver transistor (T4), is connected between the point (F1) common to the first load transistor (T3) and to the driver transistor (T4) and a write bit line (BLwr) and comprises a gate electrode connected to a write word line (WLwr).

**9.** Memory cell according to claim 8, **characterized in that** the additional access transistor (T5) comprises an additional gate electrode.

**10.** Memory cell according to claim 9, **characterized in that** the two gate electrodes of the additional access transistor (T5) are connected to one another.

**Patentansprüche**

**1.** SRAM-Speicherzelle, die einen Zugangstransistor (T1) umfasst, mit einer ersten Steuerelektrode, die mit einer Wortleitung (WL) verbunden ist, einer ersten Source-/Drain-Elektrode, die mit einer Bitleitung (BL) verbunden ist, und einer zweiten Source-/Drain-Elektrode, die mit einer Steuerelektrode eines ersten Lasttransistors (T3), einer Steuerelektrode eines Leitungstransistors (T4) und einer ersten Source-/Drain-Elektrode eines zweiten Lasttransistors (T2) verbunden ist, wobei eine zweite Source-/Drain-Elektrode des zweiten Lasttransistors (T2) an eine Versorgungsspannung gelegt ist, wobei der erste Lasttransistor (T3) und der Leitungstransistor (T4) in Reihe an die Klemmen der Versorgungsspannung geschaltet sind, wobei die Zelle **dadurch gekennzeichnet ist, dass** der Zugangstransistor (T1) und der zweite Lasttransistor (T2) jeweils mindestens eine von der entsprechenden ersten Steuerelektrode elektrisch unabhängige zweite Steuerelektrode umfasst, wobei die zweite Steuerelektrode des Zugangstransistors (T1) mit der ersten Steuerelektrode des zweiten Lasttransistors (T2) verbunden ist und die zweite Steuerelektrode des zweiten Lasttransistors (T2) an die Versorgungsspannung gelegt ist.

**2.** Speicherzelle nach Anspruch 1, **dadurch gekennzeichnet, dass** der Zugangstransistor (T1) ein Strom-Spannungs-Kennlinie mit einem Drainstrom aufweist, der stärker von der an sein erstes Gate angelegten Spannung abhängig ist als dies bei den Strom-Spannungs-Kennlinien der anderen Transistoren der Speicherzelle der Fall ist.

**3.** Speicherzelle nach einem der Ansprüche 1 und 2, **dadurch gekennzeichnet, dass** die Lasttransistoren (T2, T3) PMOS-Transistoren sind.

**4.** Speicherzelle nach einem der Ansprüche 1 bis 3, **dadurch gekennzeichnet, dass** der Zugangstransistor (T1) und der Leitungstransistor (T4) NMOS-Transistoren sind.

**5.** Speicherzelle nach einem der Ansprüche 1 bis 4, **dadurch gekennzeichnet, dass** der Leitungstransistor (T4) und der erste Lasttransistor (T3) jeweils eine zusätzliche Steuerelektrode umfassen.

**6.** Speicherzelle nach Anspruch 5, **dadurch gekennzeichnet, dass** die beiden Steuerelektroden des Leitungstransistors (T4) miteinander verbunden sind.

7. Speicherzelle nach einem der Ansprüche 5 und 6, **dadurch gekennzeichnet, dass** die beiden Steuerelektroden des ersten Lasttransistors (T4) miteinander verbunden sind.

8. Speicherzelle nach einem der Ansprüche 1 bis 7, **dadurch gekennzeichnet, dass** ein zusätzlicher Zugangstransistor (T5) gleicher Art wie der Zugangstransistor (T1) und der Leitungstransistor (T4) zwischen den dem ersten Lasttransistor (T3) und dem Leitungstransistor (T4) gemeinsamen Punkt (F1) und einer Schreibbitleitung (BLwr) gelegt ist und eine Steuerelektrode umfasst, die mit einer Schreibwortleitung (WLwr) verbunden ist.

9. Speicherzelle nach Anspruch 8, **dadurch gekennzeichnet, dass** der zusätzliche Zugangstransistor (T5) eine zusätzliche Steuerelektrode umfasst.

10. Speicherzelle nach Anspruch 9, **dadurch gekennzeichnet, dass** die beiden Steuerelektroden des zusätzlichen Leitungstransistors (T5) miteinander verbunden sind.

Figure 1 (art antérieur)

Figure 2 (art antérieur)

Figure 3 (art antérieur)

Figure 4 (art antérieur)

Figure 5

Figure 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6442060 B
- US 7116605 B
- US 20060274569 A

**Littérature non-brevet citée dans la description**

- **Kim et al.** Independent-Gate Controlled Asymmetrical SRAM Cells in Double-Gate Technology for Improved READ Stability. *Proceeding of the 32nd European Solid state conference ESSCIRC,* Septembre 2006
- **Wang et al.** Single-Ended SRAM with High Test Coverage and Short Test Time. *IEEE journal of Solid State Circuits,* Janvier 2000, vol. 35 (1
- **YAMAOKA et al.** Low Power SRAM Menu for SOC Application using Yin-Yang Feedback Memory Cell Technology. *Symp. VLSI Circuits Dig.,* 2004, vol. 18